# FASCICULE DE BREVET EUROPEEN

(11) **EP 2 433 297 B1**
(45) Date de publication et mention de la délivrance du brevet: **24.06.2015**
(21) Numéro de dépôt: 10728752.6
(22) Date de dépôt: 12.05.2010
(51) Int. Cl.: H01L 21/306, H01L 21/311, C23F 1/00

(54) **PROCEDE DE GRAVURE D'UN MATERIAU EN PRESENCE DE PARTICULES SOLIDES**
VERFAHREN ZUM ÄTZEN EINES MATERIALS BEI ANWESENHEIT VON FESTPARTIKELN
METHOD FOR ETCHING A MATERIAL IN THE PRESENCE OF SOLID PARTICLES

(30) Priorité: 18.05.2009 FR 0953294
(43) Date de publication de la demande: 28.03.2012
(73) Titulaire: Institut Polytechnique de Grenoble, 38031 Grenoble Cedex (FR); Université Joseph Fourier, 38400 Saint-Martin-d'Hères (FR)
(72) Inventeur: BAILLET, Francis, F-38850 Paladru (FR); GONDREXON, Nicolas, F-38240 Meylan (FR)
(74) Mandataire: Casalonga
(86) Numéro de dépôt international: PCT/FR2010/050928
(87) Numéro de publication internationale: WO 2010/133787

(56) Documents cités:
- WO-A-2009/117642
- JP-A- 2 097 500
- JP-A- 61 235 584
- KR-A- 20030 093 522
- US-A1- 2004 259 366

## Description

La présente invention concerne le domaine de la gravure d'un matériau.

La présente invention peut concerner plus particulièrement le domaine de la fabrication des composants semiconducteurs, dans lequel il est généralement prévu, en cours de fabrication, de nombreuses étapes sélectives de gravure d'un matériau par rapport à un autre ou d'autres, le domaine de la récupération de tranches semiconductrices comportant des défauts, dans lequel, on veut éliminer une couche superficielle pour récupérer un substrat sous-jacent, éventuellement déjà muni d'un certain nombre de couches conformées de façon appropriée, et le domaine de l'amélioration de l'état de surface d'une couche d'un matériau

De façon générale, quand on veut éliminer une couche déposée sur un substrat, de façon sélective par rapport à une autre couche, après avoir éventuellement masqué une partie de la couche à éliminer si on veut n'en éliminer qu'une partie, deux procédés principaux existent dans le domaine de la fabrication des composants semiconducteurs.

La première famille de procédés consiste en une attaque «humide» dans laquelle on immerge la structure dont on veut attaquer une couche dans un produit de gravure, typiquement à base d'acide chlorhydrique ou fluorhydrique. Plusieurs mélanges ont été développés pour permettre une attaque sélective d'une couche par rapport à une autre, par exemple une couche d'oxyde de silicium par rapport à une couche de nitrure de silicium, une couche d'oxyde de silicium par rapport à du silicium, une couche d'un métal par rapport à une couche d'isolant.

Dans cette famille, le document US-A- 6 746 967 décrit un procédé d'oxydation du nickel dans une solution oxydante à pH contrôlé. Simplement pour accélérer l'oxydation, la présence d'ultrasons basse fréquence modifie la barrière énergétique nécessaire pour l'attaque du nickel par la solution.

La seconde famille de procédés, appelée attaque "sèche", consiste à placer la structure portant la couche à éliminer dans un plasma contenant des agents de gravure, par exemple des espèces radicalaires ou radicaux actifs de chlore, de fluor, d'oxygène, etc.

La seconde famille de procédés présente de nombreux avantages par rapport à la première, notamment du fait qu'elle permet des attaques anisotropes, et qu'elle présente souvent une meilleure sélectivité de gravure entre deux matériaux. Toutefois, elle présente l'inconvénient de nécessiter des appareillages complexes et, dans le cas où la couche à graver est portée par une tranche de silicium, de ne permettre de traiter qu'une ou deux tranches de silicium à la fois. Par contre, la première famille de procédés, bien que souvent impossible à mettre en oeuvre quand on veut procéder à des attaques fortement sélectives d'un matériau par rapport à un autre matériau, présente l'avantage de permettre des traitements par lots, de nombreuses plaquettes pouvant être disposées dans une nacelle puis immergées dans la solution de gravure.

Diverses variantes de ces deux familles de procédés sont connues de l'homme de métier. Par exemple, en ce qui concerne le procédé de gravure «humide», on propose parfois pour améliorer le résultat d'appliquer un champ électrique entre le matériau à graver et la solution de gravure.

Une troisième famille de procédés, plus généralement utilisée pour le nettoyage, le dégraissage de surfaces, consiste à plonger la surface dans un bain de nettoyage, par exemple de l'alcool, et à appliquer au milieu liquide des vibrations acoustiques à des fréquences acoustiques relativement basses, couramment de l'ordre de 20 à 45 kHz. Alors, les vibrations aident à décoller les particules de salissure de la surface à nettoyer.

Par ailleurs, dans les procédés de gravure «humide», on utilise couramment des mélangeurs pour faire circuler le liquide de gravure sur la surface du matériau à graver et éventuellement des ondes acoustiques basse fréquence, entre 1 à 40 kHz, pour améliorer le mélange. Par exemple, dans le brevet US-A- 4 544 066, la solution est agitée par des ultrasons basse fréquence pour uniformiser la réaction sur la surface. Dans le brevet US 2004/0259366, la solution qui produit une attaque directe et qui contient des particules, est agitée par une vibration acoustique dans le but de faciliter l'évacuation de l'excès de matériau issu de la gravure,

La présente invention a pour objet un procédé de gravure d'une structure incluant au moins un matériau à graver.

Il est proposé un procédé de gravure d'une structure incluant au moins un matériau à graver, qui comprend :
- choisir au moins une espèce chimique apte à réagir avec le matériau à graver,
- choisir au moins un composé soluble qui ne réagit pas avec ledit matériau mais qui est apte à libérer l'espèce chimique précitée,
- réaliser une solution contenant ledit composé et contenant une poudre de particules ou grains solides en suspension,
- placer le matériau à graver en présence de la solution,
- et produire dans la solution des ultrasons à haute fréquence, à au moins une fréquence et une puissance générant des bulles actives de cavitation en présence de ladite poudre de particules ou grains solides, telles que l'espèce chimique est générée et réagit avec le matériau à graver en produisant un composé soluble ou un précipité.

Dans le cadre de la présente invention, on entend par « espèce chimique apte à réagir avec le matériau à graver », une espèce chimique atomique et/ou une espèce chimique moléculaire et/ou une espèce chimique ionique et/ou une espèce chimique radicalaire.

La dimension des particules peut être voisine de la dimension moyenne des bulles actives de cavitation.

Les particules solides peuvent présenter une dureté supérieure à la dureté du matériau à graver.

Au moins certaines des particules solides peuvent présenter des dimensions proches ou inférieures aux dimensions des défauts de la surface du matériau à graver.

Au moins certaines des particules solides peuvent présenter des dimensions inférieures aux dimensions de trous ménagés dans le matériau à graver.

Le rapport entre lesdites dimensions peut être inférieur à un quinzième.

La dimension des particules peut être inférieure à un micron.

La surface du matériau à graver peut être immergée dans la solution.

La fréquence des ultrasons à haute fréquence peut être comprise entre 100 kHz et 3 MHz.

La fréquence des ultrasons à haute fréquence peut être comprise entre 200 kHz et 600 kHz.

Pour la gravure sélective d'une structure comprenant au moins un premier matériau à graver et au moins un second matériau, dans lequel l'espèce chimique choisie et le composé soluble peut ne pas réagir avec le second matériau.

La durée de la production des ultrasons à haute fréquence peut être déterminée pour éliminer le matériau à graver en totalité ou en partie, pour réduire la rugosité de surface du matériau à graver ou pour réduire l'épaisseur du matériau à graver.

La présente invention va maintenant être exposée plus en détail par la description de modes particuliers de réalisation, à titre d'exemples non limitatifs en relation avec des appareillages de gravure représentés schématiquement sur le dessin annexé sur lequel :
- la figure 1 représente une coupe verticale d'un appareillage, une structure à graver étant placée au-dessus d'une solution ; et
- la figure 2 représente une coupe verticale d'un appareillage, une structure à graver étant immergée dans une solution.

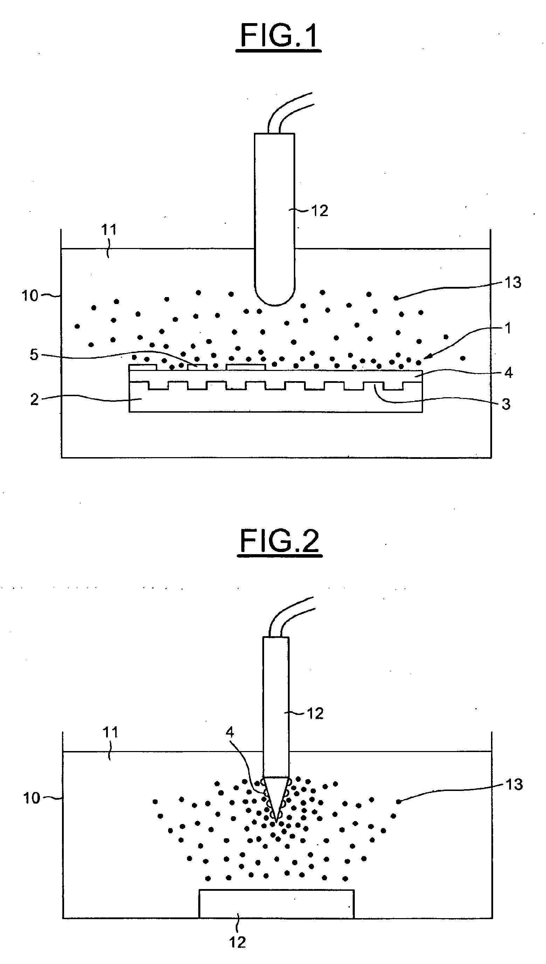

Sur la figure 1, on a représenté un appareillage qui comprend une cuvette ou enceinte 10 qui contient une solution liquide 11 et un émetteur d'ultrasons 12 ou autre source d'ondes acoustiques, au moins en partie introduit dans la solution 11, apte à générer des ondes d'ultrasons à haute fréquence dans la solution 11.

La solution 11 contient, en suspension, une poudre de particules ou grains solides 13.

Une structure 1 incluant un matériau à graver est immergée au moins en partie dans la solution 11.

On va maintenant décrire des exemples relativement à des matériaux à graver et des solutions adaptées pour la gravure de matériaux par rapport à d'autres matériaux à ne pas graver.

Dans ces exemples, pour des raisons d'écriture, les espèces chimiques aptes à réagir, qui auraient pu être marquées par un « point » sont marquées par un « o » en exposant.

### Exemple 1.

Sur la figure 1, on a représenté une structure immergée 1 en forme de plaquette comprenant une tranche de silicium 2 revêtue d'une couche isolante 3, par exemple une couche d'oxyde de silicium gravée selon un certain motif pour présenter des inégalités d'épaisseur, par exemple en damier, et revêtue d'une couche de cuivre 4. De façon courante, en pratique, une couche intermédiaire d'accrochage, par exemple une couche de nitrure de titane TiN est disposée à l'interface entre la couche d'oxyde 3 et la couche de cuivre 4.

A titre d'exemple d'ordre de grandeur, la plaquette de silicium 1 peut présenter une épaisseur de plusieurs centaines de µm, la couche d'oxyde 2 peut présenter une épaisseur inférieure à 25 µm et par exemple une épaisseur inférieure à 0,1 µm dans ses parties les plus fines, et la couche de cuivre peut présenter une épaisseur de l'ordre de 1 µm.

Dans une variante représentée sur la partie droite de la plaquette, on peut chercher à éliminer totalement la couche de cuivre 3, pour récupérer le substrat sous-jacent.

Selon une autre variante représentée sur la partie gauche de la plaquette, on peut chercher à éliminer localement une partie de la couche 3 non protégée par un masque 5 pour réaliser une étape intermédiaire de fabrication d'un dispositif semiconducteur.

Pour graver la couche de cuivre 4 de la structure 1 immergée dans la solution 11, on peut faire les choix suivants.

On peut choisir une solution 11 contenant des molécules n'attaquant ni le cuivre ni le silicium ni le masque et susceptibles de libérer une espèce chimique apte à réagir avec le cuivre, sans que cette espèce chimique ne réagisse avec le silicium et avec le matériau constituant le masque.

On peut choisir des ondes acoustiques à haute fréquence aptes à générer des bulles actives de cavitation, c'est-à-dire des ondes acoustiques ayant une fréquence supérieure à 100 kHz, par exemple comprise entre 100 kHz et 3 MHz, de préférence comprise entre 200 kHz et 3 MHz, et encore de préférence de l'ordre de 200 à 600 kHz. Dans ces plages de fréquences, la taille des bulles actives de cavitation peut atteindre des valeurs de l'ordre de 1 µm pour des fréquences de l'ordre de 400 kHz et diminue encore jusqu'à des valeurs de l'ordre de 0,1 µm pour des fréquences de l'ordre de 1 MHz.

Selon un exemple particulier, pour attaquer la couche 4 de cuivre, on peut choisir une solution d'HCl à une mole par litre et on peut choisir un émetteur d'ultrasons 12 fournissant des ondes acoustiques à une fréquence de l'ordre de 400 kHz et à une puissance de l'ordre de 300 watts.

Dans ces conditions, des bulles actives de cavitation à durée de vie très courte, dans lesquelles les pressions peuvent atteindre des valeurs de l'ordre de plusieurs atmosphères et les températures peuvent avoisiner plusieurs milliers de degrés, sont générées, notamment et plus particulièrement à la surface de la plaquette 1, et engendrent la formation de l'espèce chimique radicalaire Cl° à partir des molécules d'HCl. L'espèce chimique Cl° engendrée réagit avec le cuivre en produisant du CuCl ou du CuCl2.

La gravure obtenue est bien spécifique au phénomène de création de l'espèce chimique active Cl°. En effet, du cuivre en contact avec une solution d'HCl de même concentration ne réagit pas.

Pour les épaisseurs indiquées ci-dessus, on pourra obtenir une élimination complète de la couche 4 de cuivre métallique, totalement ou localement, sans attaque ou gravure de la couche 3 d'oxyde de silicium, c'est-à-dire sans gravure qui pourrait être supérieure à environ un nanomètre.

### Exemple 2.

Disposant d'une structure 1 incluant une plaquette de silicium 2 portant une couche d'oxyde de silicium 4, on peut chercher à éliminer cette couche d'oxyde de silicium.

On place cette plaquette 1 dans une solution 11 de NaOH (soude) à 1 mole par litre et on émet dans cette solution des ondes acoustiques à une fréquence de l'ordre de 400 kHz et à une puissance de l'ordre de 300 watts.

Dans ces conditions, comme dans l'exemple précédent, des bulles actives de cavitation générées dans la solution, notamment et plus particulièrement à la surface de la plaquette 1, engendrent la formation de l'espèce chimique OH°, à partir des molécules NaOH. L'espèce chimique radicalaire OH° engendrée réagit avec l'oxyde de silicium en produisant du H₂SiO₄.

La couche d'oxyde de silicium peut être éliminée, sans aucune attaque du silicium sous-jacent.

### Exemple 3.

Disposant d'une plaquette de silicium portant une couche de cuivre comme dans l'exemple I ou une couche d'oxyde de silicium comme dans l'exemple 2, on peut chercher à réduire la rugosité de la surface de cette couche.

Pour cela, on peut mettre en oeuvre par exemple respectivement les conditions de l'exemple 1 ou de l'exemple 2, mais on limite la durée d'action de l'émetteur 12 à ultrasons à une durée, par exemple quelques secondes, telle que seule la matière constituant les rugosités ou aspérités est attaquée au moins partiellement.

L'attaque des rugosités est d'autant plus efficace que la densité des bulles actives de cavitation est plus importante à l'extrémité de ces rugosités ou aspérités.

### Exemple 4.

Disposant d'une plaquette 1 présentant une couche de cuivre comme dans l'exemple 1 ou une couche d'oxyde de silicium comme dans l'exemple 2, on peut chercher à réduire l'épaisseur de cette couche.

Pour cela, on peut mettre en oeuvre par exemple les conditions de l'exemple 1 ou de l'exemple 2, mais on limite et on contrôle la durée d'action de l'émetteur 12 à ultrasons à haute fréquence, de telle sorte que l'épaisseur restante de la couche atteigne une valeur souhaitée.

Considérant les exemples qui précèdent, on va maintenant décrire de façon plus particulière la gravure sélective d'un premier matériau 4 par rapport à un second matériau 2, d'une structure 1, en prenant les dispositions suivantes.

On choisit une espèce chimique apte à réagir avec le premier matériau à graver et à ne pas réagir avec le second matériau.

On choisit un composé soluble qui n'attaque pas ces matériaux et apte à libérer l'espèce chimique sélectionnée.

Ayant réalisé une solution contenant ce composé et ayant immergé la structure dans la solution, on produit dans la solution des ultrasons à une fréquence apte à générer des bulles actives de cavitation.

Il en résulte que les bulles actives de cavitation, dans lesquelles les pressions atteignent des valeurs de l'ordre de plusieurs atmosphères et la température avoisine plusieurs milliers de degrés, engendrent la production, dans la solution et notamment au voisinage de la surface solide à traiter, de l'espèce chimique choisie, qui réagit sélectivement avec le premier matériau en produisant un composé soluble ou un précipité, sans attaquer le second matériau.

Pour effectuer le choix de l'espèce chimique adaptée et du composé soluble adapté, l'homme de l'art saura utiliser par exemple le logiciel "facstage" contenant la base de données européenne SGTE pour déterminer une espèce chimique susceptible de réagir avec un premier matériau pour produire un composé soluble ou facilement effritable ou un précipité, cette espèce chimique ne réagissant pas avec un second matériau.

La base de données SGTE n'est pas la seule base de données thermodynamiques à la disposition de l'homme de l'art. D'autres bases existent telles que par exemple le logiciel "thermocalc". Pour avoir accès au logiciel "thermocalc" ou au logiciel "factsage", il suffit de se connecter sur les sites Internet suivants : http://www.thermocalc.com ; www.factsage.com ; www.gtt-technologies.com

Ces bases servent de support à des logiciels qui, par minimisation d'énergie de Gibbs, sont capables de donner les composés thermodynamiquement stables qui se formeront par réaction chimique à partir d'un mélange de départ donné. Par thermodynamiquement stable, on entend un produit qui serait obtenu après un temps de réaction infini. On peut par exemple observer ce qui suit.
- un mélange de départ silice + cuivre solide + HCl dilué à 1 Mole par litre n'évolue pas (reste stable). Si on ajoute dans le calcul qu'il existe en solution des espèces radicalaires ou radicaux Cl°, le cuivre solide se transformera totalement en CuCl₂ et Cu²⁺ mais la silice n'évoluera pas.
- un mélange de départ de silicium + silice et de soude à 1 mole par litre est un mélange thermodynamiquement stable (pas d'évolution). Si l'on ajoute au calcul que l'on va former en solution les espèces chimiques radicalaire OH° ou Na°, le logiciel de thermodynamique montre que la silice sera transformée en composé Na2SiO4 solide alors que le silicium restera stable.

L'homme de l'art saura déterminer quelles espèces chimiques peuvent se former dans une solution donnée et tester, en utilisant les logiciels susmentionnés, quelles phases (composés ou corps purs) seront stables en solution et lesquelles évolueront par réaction chimique.

On peut noter les exemples suivants, pour le choix d'une espèce chimique destinée à graver un premier matériau sans attaquer un second matériau d'une plaquette.

L'espèce chimique OH° peut être active pour attaquer ou graver Si, sans attaquer SiGe.

L'espèce chimique H° peut être active pour graver InSnO₃, sans attaquer SiO₂.

L'espèce chimique Cl° peut être active pour attaquer ou graver Cu, sans attaquer SiO₂.

L'espèce chimique F° peut être active pour attaquer ou graver Si, sans attaquer un polymère.

L'espèce chimique Cl° peut être active pour attaquer ou graver Au, sans attaquer une céramique AIN.

L'espèce chimique OH° ou l'espèce chimique Cl° peut être active pour attaquer ou graver Al, sans attaquer Al₂O₃.

L'espèce chimique OH° peut être active pour attaquer ou graver W, sans attaquer Al₂O₃.

L'espèce chimique Cl° peut être active pour attaquer ou graver Cu, sans attaquer SiO₂ ou une céramique TiN.

L'espèce chimique H° ou l'espèce chimique Cl° peuvent être actives pour attaquer ou graver InSnO₂, sans attaquer un polymère ou un verre.

L'espèce chimique Na° ou l'espèce chimique F° peuvent être actives pour attaquer ou graver SiO₂, sans attaquer Al.

L'espèce chimique H° ou l'espèce chimique F° peuvent être actives pour attaquer ou graver Al₂O₃, sans attaquer W.

L'espèce chimique Br° peut être active pour attaquer ou graver TiN, sans attaquer SiO₂.

L'espèce chimique K° peut être active pour attaquer ou graver Si₃N₄, sans attaquer SiO ou un polymère.

L'espèce chimique Cl° peut être active pour attaquer où graver une céramique TaN, sans attaquer SiO₂.

Par ailleurs, l'homme de l'art saura, par des essais simples, déterminer dans chaque cas particulier la concentration de la solution choisie, la fréquence optimale et la puissance optimale des ultrasons pour que l'effet des bulles actives de cavitation produites engendre l'attaque souhaitée, ainsi que la durée du traitement à appliquer au premier matériau à graver.

On peut noter la grande simplicité du procédé de mise en oeuvre, et le fait que l'on peut traiter simultanément, dans une même solution, un lot de structures 1.

Dans un autre exemple représenté sur la figure 2, il est proposé de réaliser le nettoyage de l'extrémité de pointes 2 de contact électrique salies par un dépôt de particules 4 à enlever, en particulier l'attaque chimique de particules d'aluminium déposées sur des pointes en tungstène utilisées pour effectuer le test de puces électroniques, les extrémités salies des pointes étant plongées dans une solution 11. Dans ce cas, on peut choisir une solution de NaCl, qui n'attaque ni l'aluminium ni le tungstène mais qui pourra libérer des espèces chimiques Cl° pour attaquer l'aluminium sans attaquer le tungstène.

Dans l'ensemble des exemples de gravure qui viennent d'être décrits, la poudre de particules solides 13 peut être choisie pour assurer les effets suivants.

Les particules solides 13 en suspension dans la solution 11 peuvent servir de germes à la création des bulles actives de cavitation. En conséquence, la présence des particules solides 13 en suspension dans la solution 11, notamment à proximité de la surface du matériau à graver 4, peut permettre d'augmenter le nombre de bulles actives de cavitation créées sous l'effet des ultrasons à haute fréquence.

Cette augmentation du nombre de bulles actives de cavitation peut permettre une augmentation du nombre d'espèces chimiques libérées, ce qui peut avoir pour effet d'accélérer l'attaque chimique du matériau à graver.

Une augmentation conséquente advient dans la mesure où la dimension des particules solides 11 est proche de ou plus petite que la dimension des bulles actives de cavitation créées. En particulier, la dimension des particules solides 11, pour au moins la plupart d'entre elles, peut être voisine ou inférieure à 0,5 micron.

Les particules solides 13 en suspension dans la solution 11 peuvent être agitées sous l'effet des ultrasons à haute fréquence et peuvent subir des déplacements sous l'effet en particulier de l'implosion des bulles actives de cavitation et des effets hydrodynamiques associés. En conséquence, les particules solides qui subissent ces déplacements et qui sont situées à proximité ou en contact avec la surface du matériau à graver peuvent engendrer une micro-abrasion mécanique de cette surface.

D'une part, cette abrasion peut également contribuer à accélérer l'attaque chimique du matériau à graver.

D'autre part, cette abrasion peut produire un effet de polissage de la surface du matériau à graver, en attaquant les aspérités de cette dernière. Cette abrasion peut aussi produire un effet de polissage des parois de trous ménagés dans la surface de la matière à graver.

Pour qu'une telle abrasion soit efficace, les particules solides 13 peuvent présenter une dureté supérieure à la dureté du matériau à graver pour que les particules solides 13 ne soient pas endommagées et produisent leur effet d'abrasion. En fonction du matériau 4 à graver, le choix peut avantageusement porter sur des particules de carbure de silicium (SiC), d'alumine (Al₂O₃) de silice (SiO₂) ou de zircone (ZrO₂). Dans le cas d'un verre à graver ou à polir, le carbure de silicium (SiC) conviendrait particulièrement.

De plus, la dimension des particules solides 11, pour au moins la plupart d'entre elles, peut être voisine de la dimension des creux entre les aspérités de surface. Cependant, dans le cas où l'on souhaite un polissage ou un nettoyage de la paroi de trous ménagés dans la surface de la matière à graver, il peut être avantageux que la dimension des particules solides, pour au moins la plupart d'entre elles, soit voisine ou inférieure au dixième de la dimension des trous pour aisément y pénétrer. Pour des trous d'un micron de diamètre, des particules solides 11 d'un dixième de micron ou inférieure conviendraient.

Dans tous les cas, les particules solides 13 doivent, pour au moins la plupart d'entre elles, être en suspension dans la solution 11 pendant l'opération de gravure et ne pas décanter. Pour éviter une telle décantation, une agitation de la solution 11 par un moyen adapté peut être additionnée.

La densité des particules solides 13 dans la solution 11 peut en outre être adaptée aux effets souhaités. En particulier, pour obtenir un effet significatif, il peut être judicieux qu'au moins 15 à 20 particules soient présentes entre deux aspérités. L'action d'abrasion étant isotrope (dans toutes directions), les pointes des aspérités peuvent être plus attaquées et les défauts de surfaces peuvent être réduits.

## Revendications

1. Procédé de gravure d'une structure (1) comprenant au moins un matériau à graver (4), comprenant :
- choisir au moins une espèce chimique apte à réagir avec le matériau à graver (4),
- choisir au moins un composé soluble qui ne réagit pas avec ledit matériau mais qui est apte à libérer l'espèce chimique précitée,
- réaliser une solution (11) contenant ledit composé et contenant une poudre de particules ou grains solides (13) en suspension,
- placer le matériau à graver en présence de la solution,
- et produire dans la solution des ultrasons à haute fréquence, à au moins une fréquence et une puissance générant des bulles actives de cavitation en présence de ladite poudre de particules ou grains solides, telles que l'espèce chimique est générée et réagit avec le matériau à graver en produisant un composé soluble ou un précipité.

2. Procédé selon la revendication 1, dans lequel la dimension des particules est voisine de la dimension moyenne des bulles actives de cavitation.

3. Procédé selon l'une des revendications 1 et 2, dans lequel les particules solides présentent une dureté supérieure à la dureté du matériau à graver.

4. Procédé selon l'une quelconque des revendications précédentes, dans lequel au moins certaines des particules solides présentent des dimensions proches ou inférieures aux dimensions des défauts de la surface du matériau à graver.

5. Procédé selon l'une quelconque des revendications précédentes, dans lequel au moins certaines des particules solides présentent des dimensions inférieures aux dimensions de trous ménagés dans le matériau à graver.

6. Procédé selon la revendication 4 ou 5, dans lequel le rapport entre lesdites dimensions est inférieur à un quinzième.

7. Procédé selon l'une quelconque des revendications précédentes, dans lequel la dimension des particules est inférieure à un micron.

8. Procédé selon l'une quelconque des revendications précédentes, dans lequel la surface du matériau à graver est immergée dans la solution.

9. Procédé selon l'une quelconque des revendications précédentes, dans lequel la fréquence des ultrasons à haute fréquence est comprise entre 100 kHz et 3 MHz.

10. Procédé selon l'une quelconque des revendications précédentes, dans lequel la fréquence des ultrasons à haute fréquence est comprise entre 200 kHz et 600 kHz.

11. Procédé selon l'une quelconque des revendications précédentes, pour la gravure sélective d'une structure (1) comprenant au moins un premier matériau à graver (4) et au moins un second matériau (2), dans lequel l'espèce chimique choisie et le composé soluble ne réagissent pas avec le second matériau (3).

12. Procédé selon l'une quelconque des revendications précédentes, dans lequel la durée de la production des ultrasons à haute fréquence est déterminée pour éliminer le matériau à graver en totalité ou en partie, pour réduire la rugosité de surface du matériau à graver ou pour réduire l'épaisseur du matériau à graver.

## Patentansprüche

1. Verfahren zum Ätzen einer mindestens ein zu ätzendes Material (4) enthaltenden Struktur (1), das enthält:
- die Wahl mindestens einer chemischen Spezies, die mit dem zu ätzenden Material (4) reagieren kann,
- die Wahl mindestens einer löslichen Verbindung, die nicht mit dem Material reagiert, sondern die erwähnte chemische Spezies freisetzen kann,
- die Herstellung einer Lösung (11), die die Verbindung enthält, und die ein Pulver aus Feststoffteilchen oder -körnern (13) in Schwebe enthält,
- das zusammenbringen des zu ätzenden Materials mit der Lösung,
- und die Erzeugung in der Lösung von hochfrequenten Ultraschallwellen mit mindestens einer Frequenz und einer Leistung, die derartige aktive Kavitationsblasen in Gegenwart des Pulvers von Feststoffteilchen oder -körnern erzeugen, dass die chemische Spezies erzeugt wird und mit dem zu ätzenden Material reagiert, indem eine lösliche Verbindung oder ein Niederschlag hergestellt wird.

2. Verfahren nach Anspruch 1, wobei die Abmessung der Teilchen nahe der mittleren Abmessung der aktiven Kavitationsblasen ist.

3. Verfahren nach einem der Ansprüche 1 und 2, wobei die Feststoffteilchen eine größere Härte als die Härte des zu ätzenden Materials aufweisen.

4. Verfahren nach einem der vorhergehenden Ansprüche, wobei mindestens bestimmte der Feststoffteilchen Abmessungen nahe den oder kleiner als die Abmessungen der Fehler der Oberfläche des zu ätzenden Materials aufweisen.

5. Verfahren nach einem der vorhergehenden Ansprüche, wobei mindestens bestimmte der Feststoffteilchen kleinere Abmessungen als die Abmessungen von Löchern aufweisen, die im zu ätzenden Material ausgespart sind.

6. Verfahren nach Anspruch 4 oder 5, wobei das Verhältnis zwischen den Abmessungen geringer als ein Fünfzehntel ist.

7. Verfahren nach einem der vorhergehenden Ansprüche, wobei die Abmessung der Teilchen kleiner als 1 Mikron ist.

8. Verfahren nach einem der vorhergehenden Ansprüche, wobei die Oberfläche des zu ätzenden Materials in die Lösung eingetaucht wird.

9. Verfahren nach einem der vorhergehenden Ansprüche, wobei die Frequenz der hochfrequenten Ultraschallwellen zwischen 100 kHz und 3 MHz liegt.

10. Verfahren nach einem der vorhergehenden Ansprüche, wobei die Frequenz der hochfrequenten Ultraschallwellen zwischen 200 kHz und 600 kHz liegt.

11. Verfahren nach einem der vorhergehenden Ansprüche zum selektiven Ätzen einer Struktur (1), die mindestens ein erstes zu ätzendes Material (4) und mindestens ein zweites Material (2) enthält, wobei die gewählte chemische Spezies und die lösliche Verbindung nicht mit dem zweiten Material (3) reagieren.

12. Verfahren nach einem der vorhergehenden Ansprüche, wobei die Dauer der Erzeugung der hochfrequenten Ultraschallwellen festgelegt wird, um das zu ätzende Material vollständig oder teilweise zu entfernen, um die Oberflächenrauigkeit des zu ätzenden Materials zu reduzieren oder um die Dicke des zu ätzenden Materials zu reduzieren.

## Claims

1. Method for etching a structure (1) comprising at least one material to be etched (4), comprising:
- choosing at least one chemical species capable of reacting with the material to be etched (4);
- choosing at least one soluble compound that does not react with said material but which is able to release the aforementioned chemical species;
- producing a solution (11) containing said compound and containing a powder of solid grains or particles (13) in suspension;
- placing the material to be etched in the presence of the solution; and
- producing high-frequency ultrasound in the solution with at least a frequency and a power generating active cavitation bubbles in the presence of said powder of soild grains or particles, such that the chemical species is generated and reacts with the material to be etched, while producing a soluble compound or a precipitate.

2. Method according to Claim 1, in which the size of the particles is similar to the mean size of the active cavitation bubbles.

3. Method according to either of Claims 1 and 2, in which the solid particles exhibit a hardness greater than the hardness of the material to be etched.

4. Method according to any one of the preceding claims, in which at least some of the solid particles exhibit sizes close to or less than the sizes of the defects of the surface of the material to be etched.

5. Method according to any one of the preceding claims, in which at least some of the solid particles exhibit sizes less than the sizes of holes made in the material to be etched.

6. Method according to Claim 4 or 5, in which the ratio between said sizes is less than a fifteenth.

7. Method according to any one of the preceding claims, in which the size of the particles is less than one micron.

8. Method according to any one of the preceding claims, in which the surface of the material to be etched is immersed in the solution.

9. Method according to any one of the preceding claims, in which the high-frequency ultrasound frequency lies between 100 kHz and 3 MHz.

10. Method according to any one of the preceding claims, in which the high-frequency ultrasound frequency lies between 200 kHz and 600 kHz.

11. Method according to any one of the preceding claims, for the selective etching of a structure (1) comprising at least one first material to be etched (4) and at least one second material (2), in which the chosen chemical species and the soluble compound do not react with the second material (3).

12. Method according to any one of the preceding claims, in which the period during which high-frequency ultrasound is produced is determined in order totally or partially to remove the material to be etched, in order to reduce the surface roughness of the material to be etched or in order to reduce the thickness of the material to be etched.
